# EUROPÄISCHE PATENTSCHRIFT

(11) **EP 1 801 688 B1**
(45) Veröffentlichungstag und Bekanntmachung des Hinweises auf die Patenterteilung: **24.08.2011**
(21) Anmeldenummer: 06024655.0
(22) Anmeldetag: 28.11.2006
(51) Int. Cl.: G06F 1/18, H05K 7/14

(54) **Computergehäuse**
Computer housing
Boîtier d' ordinateur

(30) Priorität: 23.12.2005 DE 102005061824
(43) Veröffentlichungstag der Anmeldung: 27.06.2007
(73) Patentinhaber: Fujitsu Technology Solutions Intellectual Property GmbH, 80807 München (DE)
(72) Erfinder: Müller-Augste, Frank, 86199 Augsburg (DE); Treffler, Roland, 86167 Augsburg (DE)
(74) Vertreter: Epping - Hermann - Fischer

(56) Entgegenhaltungen:
- US-A1- 2003 230 429
- US-B1- 6 259 032
- US-B1- 6 424 538
- US-B1- 6 695 629

## Beschreibung

Die Erfindung betrifft ein Computergehäuse mit einem Trägerblech, das zur Befestigung einer Leiterplatte eingerichtet ist, mit zumindest einem Stehbolzen zur Befestigung der Leiterplatte, der an dem Trägerblech angeordnet ist und einen Bolzenfuß und einen Bolzenkopf aufweist, wobei das Trägerblech in einem Computergehäuse angeordnet ist.

Computergehäuse sind Massenprodukte, die einem hohen Preiskampf unterliegen. Aufgrund des hohen Preiskampfes und der produzierten hohen Stückzahlen sind Einsparungen bei der Montage eines Computersystems, auch im Sekundenbereich, von äußerster Bedeutung. Einsparungen sind besonders wirkungsvoll, wenn sie sich auf die Montagezeiten von Computergehäusen oder deren Komponenten beziehen. So befinden sich innerhalb eines gesamten Montageprozesses von Computern Teilprozesse, welche sich mit der Montage von Computermainboards, Controllern oder anderen Leiterplatten des Computers befassen. Die Montage einer Leiterplatte ist ein solcher Teilprozess.

Zur Montage einer Leiterplatte in einem Gehäuse sind verschiedene Vorgehensweisen und Anordnungen nach dem allgemeinen Stand der Technik bekannt. Eine dieser bekannten Vorgehensweisen ist die Montage einer Leiterplatte direkt an einer Gehäusewandung mittels Schraubverbindungen. Dabei sind Befestigungssockel vorgesehen, welche eine mittige Bohrung aufweisen, die zur Aufnahme der Schraube eingerichtet sind. Mittels der Befestigungssockel ist die Leiterplatte von der Gehäusewandung beabstandet.

Des Weiteren ist eine schraubenlose Befestigung aus der Druckschrift DE 101 06 555 A1 bekannt. Dabei ist an einer Wandung in einem Computer ein hakenförmiger Vorsprung vorgesehen. Die Leiterplatte wird so in das Gehäuse an der Wandung eingesetzt, dass durch eine entsprechende Öffnung in der Leiterplatte der hakenförmige Vorspruch steckbar ist. Die Fixierung der Leiterplatte erfolgt durch einen weiteren Vorsprung, welcher ebenso von der Wandung des Computergehäuses absteht. Dieser wirkt mit einer weiteren Öffnung der Leiterplatte derart zusammen, dass nach dem Hinterschieben der Leiterplatte unter einen Hinterschnitt des hakenförmigen Vorsprungs in den weiteren Vorsprung eine Schraube oder ein Klemmstift eindrehbar beziehungsweise einsteckbar ist.

Die US 6,259,032 B1 offenbart eine Leiterplattenerdungsvorrichtung mit mehreren Schlitzen, die mit mehreren leitenden Stehbolzen zusammenwirken. Jeder der Stehbolzen weist einen sich verjüngenden von einem Hals getragenen Kopf und einen Fuß auf, der mit einem leitenden Element gekoppelt ist. Ein schmaler Abschnitt des sich verjüngenden Kopfs jedes Stehbolzens durchdringt einen entsprechenden Schlitz in der Leiterplatte, wodurch die Leiterplatte zu den Stehbolzen ausgerichtet wird.

Eine Leiterplattenbefestigung in einem Computergehäuse erfüllt über die alleinige Befestigung hinaus noch weitere Funktionen, wie zum Beispiel einen Massekontakt zwischen Leiterplatte und Gehäuse herzustellen.

Es ist demzufolge die Aufgabe der Erfindung, ein Computergehäuse derart weiterzubilden, dass bei der Montage einer Leiterplatte gegenüber dem bisherigen Stand der Technik Montagezeit eingespart werden kann, und ein sicherer elektrischer Kontakt als Massekontakt zwischen Leiterplatte und Computergehäuse herstellbar ist.

Diese Aufgabe wird durch die Maßnahmen der Patentansprüche 1 und 11 gelöst und durch die Maßnahmen der untergeordneten Patentansprüche 2 bis 10 und von 12 bis 15 in vorteilhafter Weise weitergebildet.

Dabei ist vorgesehen, ein Trägerblech, das zur Befestigung einer Leiterplatte eingerichtet ist, mit zumindest einem Stehbolzen, der an dem Trägerblech vertikal angeordnet ist und welcher einen Bolzenfuß und einen Bolzenkopf aufweist, so auszugestalten, dass zwischen dem Bolzenfuß und dem Bolzenkopf eine Verjüngung ausgebildet ist, wobei der Bolzenfuß zu der Verjüngung hin kegelförmig ausgebildet ist. Der Bolzenkopf weist eine Grundfläche auf welche eine Ebene bildet, die parallel zu einer Oberfläche der aufgenommenen Leiterplatte ist, und die einen elektrischen Kontakt als Massekontakt zwischen der Leiterplatte und dem Computergehäuse bildet.

Weiterhin ist vorgeschlagen, eine Anordnung vorzusehen mit einem Trägerblech dem oben beschriebenen Prinzip folgend, welches mit einer Leiterplatte zusammenwirkt. Dabei weist die Leiterplatte eine Öffnung auf, die dazu eingerichtet ist, mit dem Stehbolzen zusammenzuwirken und deren Abmessungen so ausgebildet sind, dass der Bolzenkopf durch die Öffnung hindurchführbar ist. Weiter weist die Öffnung eine Verjüngung zu einem Ende hin auf, so dass das Board den Bolzenkopf untergreift.

Die Vorteile der vorgenannten Maßnahmen liegen darin, dass die Leiterplatte keiner weiteren Befestigung bedarf. Mittels des kegelformigen Bolzenfußes zu der Verjüngung hin wird eine Kraft gegenüber der Leiterplatte ausgeübt, die sie im montierten Zustand gegen den Bolzenkopf drückt.

Durch die kegelförmige Ausbildung des Bolzenfußes wird im zusammenhang mit dem Bolzenkopf erreicht, dass eine Leiterplatte zwischen dem Bolzenfuß und dem Bolzenkopf klemmend befestigbar ist.

Der Stehbolzen selbst ist mit dem Trägerblech elektrisch leitend verbunden, dies kann eine Schweißverbindung, eine Klemmverbindung, eine Schraubverbindung oder eine Nietverbindung sein. Alle diese Verbindungsarten sind in einem automatisierten Herstellungsprozess einfach herzustellen und damit kostengünstig umzusetzen und garantieren eine sichere Leitfähigkeit zwischen dem Stehbolzen und der Gehäusewandung. Insbesondere zur Herstellung einer leitfähigen Verbindung zwischen der Leiterplatte und der Computerwandung ist es vorteilhaft, den Stehbolzen mit einer elektrisch leitfähigen Oberfläche auszustatten oder ihn, aufgrund der elektrisch leitenden Eigenschaften von Metall aus einem metallischen Werkstoff zu fertigen.

In einer vorteilhaften Ausführungsform ist der Bolzenfuß zylinderförmig ausgebildet und der Bolzenkopf kegelförmig ausgebildet. Es ist weiter vorteilhaft, den Bolzenkopf an seiner zum Trägerblech hin gerichteten Seite mit einer Einführschräge zu versehen. Diese erleichtert das Einführen einer Leiterplatte beim Montageprozess. Das Risiko einer Verkantung während des Montageprozesses ist mit der Einführschräge vermindert.

Um den Herstellungsprozess des Stehbolzens an sich zu vereinfachen, ist es vorteilhaft, den Bolzenfuß und den Bolzenkopf jeweils in einer kreisförmigen Grundfläche zu gestalten, wobei der Durchmesser der Grundflächen voneinander verschieden ist. So ist es vorteilhaft, den Durchmesser der Grundfläche des Bolzenfußes größer als den Durchmesser der Grundfläche des Bolzenkopfes zu gestalten. Diese kreisförmige Grundfläche ist durch sehr einfache Herstellungsprozesse, wie zum Beispiel Drehen, in großen Stückzahlen einfach erstellbar. Andererseits ist es auch möglich, so einen Bolzenkopf durch ein dem Nietverfahren ähnliches Verfahren mit der Leiterplatte zu verbinden und den Bolzenkopf durch ein hämmerndes also mechanisch kaltverformendes Verfahren herzustellen. Weiterhin ist es möglich, den fertigen Stehbolzen mit einem Schweissverfahren mit dem Trägerblech zu verbinden, oder einen Stehbolzenrohling mit einem Schweissverfahren mit dem Trägerblech zu verbinden und mit einer mechanischen Kaltverformung den Bolzenkopf nach dem Schweißverfahren zu bilden. Die hier nur kurz vorgestellten Verfahrensweisen stellen günstige Möglichkeiten dar, den Stehbolzen am Trägerbleich zu befestigen und den Stehbolzen herzustellen. All diese Verfahren sind günstig in einen Fließbandprozess integrierbar und somit ist in einfacher Weise die Produktion eines Computergehäuses mit einem Trägerblech und einem Stehbolzen gemäß dem vorstehend beschriebenen Prinzip möglich.

Eine kegelförmige oder pilzförmige Ausbildung des Bolzenkopfes erleichtert zudem das Einführen des Bolzenkopfes beziehungsweise das Einführen des Stehbolzens in eine Öffnung in der Leiterplatte. Es ist weiter vorteilhaft, nicht nur Bolzenkopf und Bolzenfuß zylindrisch zu gestalten und damit mit kreisförmigen Grundflächen zu versehen, sondern auch die Verjüngung selbst in einer kreisförmigen Grundfläche zu erstellen. Dies vereinfacht den Produktionsprozess des Stehbolzens in vorteilhafter Weise.

Eine jede Leiterplatte weist eine bestimmte Dicke auf, die allerdings von Leiterplatte zu Leiterplatte variiert. Durch die kegelförmige, zylindrische Oberfläche des Bolzenfußes im Zusammenspiel mit der zylindrischen Verjüngung ist eine Anpassung der Leiterplattendicke an den Stehbolzen möglich. Eine Leiterplatte, deren Dicke ein wenig stärker ist als die Höhe der Verjüngung, findet eine klemmende Verbindung zwischen Bolzenkopf und Bolzenfuß. Eine Leiterplatte, die so dünn ist bzw. deren Dicke geringer ist als die Höhe der zylindrischen Verjüngung, wird keine klemmende Verbindung mit dem Bolzenkopf erreichen. Dies zeigt zwar die Grenzen der erfindungsgemäßen Befestigung auf, wobei damit die Vorteile jedoch unberührt sind, da in der Regel Computer keine sehr dünnen oder flexiblen Leiterplatten aufweisen. Vielmehr variieren die Leiterplattendicken innerhalb eines vorbekannten Dickenbereichs, so dass die Höhe der zylindrischen Verjüngung auf die zur Verwendung kommenden Leiterplatten abgestimmt werden kann.

Um eine Leiterplatte in einem Gehäuse zu befestigen, ist es von Vorteil, wenn der Bolzenfuß an einer zur Innenseite hin weisenden Fläche des Trägerblechs angeordnet ist. Damit die Leiterplatte den Bolzenkopf untergreift, und damit eine formschlüssige Befestigung gebildet ist, ist es vorteilhaft, den Durchmesser der kreisförmigen Grundfläche des Bolzenkopfes größer als den Durchmesser der kreisförmigen Grundfläche des Bolzenfußes zu gestalten.

Die Zahl der Stehbolzen ist für die Befestigung der Leiterplatte von untergeordneter Bedeutung. Prinzipiell genügt ein Stehbolzen, um eine Leiterplatte zu befestigen. So können Verdrehungen der Leiterplatte, die durch die Befestigung mit nur einem Stehbolzen alleine nicht zu vermeiden sind, durch andere Mittel, zum Beispiel Stützsockel oder Blechlaschen, vermieden werden. Dennoch ist es mitunter vorteilhaft, zwei, drei, vier oder noch mehr Stehbolzen zur Befestigung von Leiterplatten vorzusehen, wobei mit steigender Anzahl der Stehbolzen die Montage der Leiterplatte schwieriger wird und mit geringerer Anzahl der Stehbolzen die Sicherheit der Befestigung sinkt. Ein Optimum ist bei einer Anzahl von etwa vier Stehbolzen für eine Leiterplatte zu finden. Die optimale Anzahl von Stehbolzen zur Befestigung einer Leiterplatte ist jedoch auch von der geometrischen Form der Leiterplatte abhängig.

Die Erfindung wird, wie bereits vorgehend erwähnt, auch gelöst durch eine Anordnung mit einem Computergehäuse mit einem Trägerblech, welches einen Stehbolzen gemäß den vorgehend beschriebenen Prinzip aufweist, und einer Leiterplatte, die eine Öffnung aufweist, die dazu eingerichtet ist, mit dem Stehbolzen zusammenzuwirken und deren Abmessungen so ausgebildet sind, dass der Bolzenkopf durch die Öffnung hindurchführbar ist. Die Öffnung weist eine Verjüngung zu einem Ende hin auf, so dass sich in einer Verriegelungsposition der Leiterpatte mit der Verjüngung des Stehbolzens und der Verjüngung der Öffnung eine klemmende Verbindung ergibt.

Es ist vorteilhaft, insbesondere im Zusammenspiel mit dem Bolzenkopf und dem Bolzenfuß, wenn die Öffnung in der Leiterplatte eine kreisrunde Bohrung ist, welche einen Mindestdurchmesser umfasst, der zumindest dem Durchmesser des Bolzenkopfes gleich ist. Damit ist der Bolzenkopf problemlos durch diese kreisrunde Bohrung hindurch zu führen. Diese Bohrung ist in vorteilhafter Weise mit einem Langloch erweitert, sodass sich schließlich eine schlüsselförmige Öffnung ergibt. Die Breite dieses Langloches ist zumindest gleich dem Durchmesser der zylindrischen Verjüngung, sodass die zylindrische Verjüngung entlang des Langloches verschiebbar ist. Am Ende des Langloches nimmt die Leiterplatte durch die zylindrische Form des Bolzenfußes eine klemmende Verbindung ein, da die Oberfläche der Leiterplatte aufgrund der kegelförmigen Ausbildung des Übergangs von Bolzenfuß zur Verjüngung gegen den Bolzenkopf drückt. Somit ist die Leiterplatte entlang dieses Langloches unter dem Bolzenkopf verschiebbar, wobei die Verjüngung des Bolzenfußes in dem Langloch bewegt wird. Es ist vorteilhaft, wenn das Höhenmaß der Verjüngung so eingerichtet ist, dass es gleich oder geringer als die Dicke der Leiterplatte ist, sodass die Leiterplatte zwischen Bolzenkopf und Bolzenfuß klemmend befestigt ist.

Die Öffnung in der Leiterplatte ist mit elektrisch leitfähigen Kontaktstellen umgeben. Diese Kontaktstellen sind wahlweise beidseitig der Leiterplatte oder nur an einer Seite der Leiterplatte angeordnet und sind in Form von Kontaktlötpunkten oder auch unisolierten Leiterbahnen der Leiterplatte gebildet. Durch den kegelförmigen Übergang von dem Bolzenfuß mit großem Durchmesser zu der Verjüngung mit geringeren Durchmesser wird die Leiterplatte durch das Verschieben in das Langloch gegen den Bolzenkopf gepresst. Im Zusammenspiel mit Bolzenkopf und den Kontaktstellen ist eine elektrische Verbindungen mit dem Gehäuse hergestellt.

Für die vorstehend beschriebene Erfindung ist die Art der Leiterplatte von untergeordneter Bedeutung. So kann die Leiterplatte eine Grafikkarte, ein Controller, ein Computermainboard oder eine andere Komponente eines Computers sein.

Somit ist in vorteilhafter Weise eine schraublose Befestigung der Leiterplatte im Gehäuse unter Berücksichtigung der elektrischen Kontaktierung der Leiterplatte im Gehäuse erfüllt.

Unterschiedliche Stärken beziehungsweise Dicken der Leiterplatten sind aufgrund der Formgebung des Stehbolzens nunmehr von untergeordneter Bedeutung. Leiterplatten unterschiedlicher Stärke erfahren gleichermaßen eine klemmende Befestigung durch den Stehbolzen.

Mittels der klemmenden Verbindung ist eine sichere Befestigung erreicht, die ohne Schrauben und ohne weiteren zusätzlichen Montageaufwand herstellbar ist. Der Vorteil der Erfindung liegt insbesondere darin, dass der zeitliche Anteil der Montage der Leiterplatte in dem Computergehäuse damit stark sinkt.

Die Erfindung ist im Folgenden anhand eines Ausführungsbeispieles und fünf Figuren näher beschrieben. Es zeigen die
Figur 1, eine Ausschnittsdarstellung einer Leiterplatte 1 mit einem Stehbolzen,
Figur 2, die Leiterplatte mit Stehbolzen teilmontiert,
Figur 3, die Leiterplatte mit Stehbolzen teilmontiert in einer Seitenansicht,
Figur 4, fertig montierte Leiterplatte mit Stehbolzen,
Figur 5, fertig montierte Leiterplatte mit Stehbolzen in einer Steitenansicht.

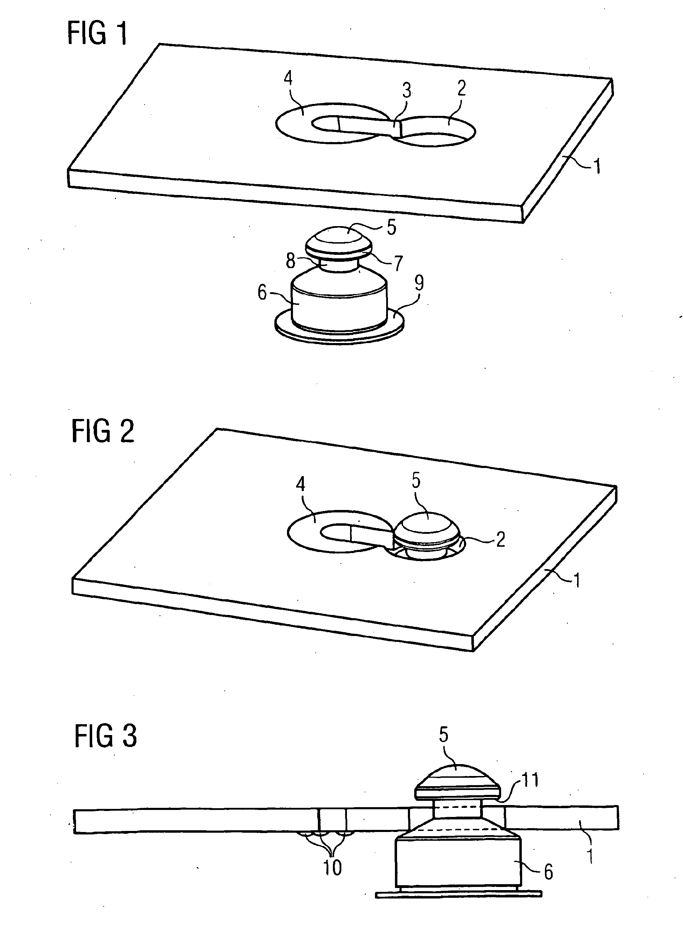

Figur 1 zeigt eine Leiterplatte 1 mit einer kreisrunden Bohrung 2, einem Langloch 3, das die Bohrung in einer Richtung verlängert, sodass eine schlüssellochförmige Öffnung gebildet ist. Diese schlüssellochförmige Öffnung ist teilweise umgeben von Kontaktstellen 4, die einen elektrischen Kontakt, zum Beispiel mit einem Stehbolzen oder einem anderen Befestigungsmittel, herstellen.

Weiter ist in Figur 1 ein Stehbolzen 5 gezeigt, mit einem Bolzenfuß 6 und einem Bolzenkopf 7. Der Stehbolzen 5 weist eine kegelförmige Oberfläche auf, die zu einer Verjüngung 8 hinführt, wobei die Verjüngung 8 zwischen dem Bolzenfuß 6 und dem Bolzenkopf 7 angeordnet ist. Der Durchmesser der Verjüngung 8 ist dabei geringer als der Durchmesser des Bolzenkopfes 7 und der Durchmesser des Bolzenkopfes 7 ist geringer als der Durchmesser des Bolzenfußes 6.

Symbolisch ist in der Figur 1 ein Trägerblech 9 in einem kleinen Ausschnitt gezeigt. Auf dem Trägerblech 9 ist in vertikaler Richtung zur Oberfläche des Trägerblechs 9 der Stehbolzen 5 angeordnet. Der gezeigte Ausschnitt des Trägerblechs 9 betrifft das den Stehbolzen 5 unmittelbar umgebende Trägerblech 9. Dies ist der für die Beschreibung der Erfindung wesentliche Ausschnitt. Zur Befestigung der Leiterplatte 1 auf einem Trägerblech 9 genügt zumindest ein einziger Stehbolzen 5 gemäß dem vorstehend beschriebenen Prinzip. Seitliche Verschiebungen oder Drehungen der Leiterplatte 1 sind durch weitere Komponenten wie Blechlaschen oder Stützelemente verhinderbar, die nicht Teil dieser Erfindung sind. Eine Mehrzahl von Stehbolzen 5 zur Befestigung der Leiterplatte 1 auf dem Trägerblech 1 ist in Abhängigkeit von der geometrischen Form der Leiterplatte von Vorteil. Mit steigender Anzahl der Stehbolzen 5 erhöht sich die Stabilität der Befestigung, aber auch der zeitliche Montageaufwand. Was die Stabilität der Befestigung betrifft, sind zwei Stehbolzen 5 besser als einer und drei Stehbolzen 5 möglicherweise auch besser als zwei. Ein Optimum der Anzahl der verwendeten Stehbolzen 5 liegt möglicherweise bei vier Stehbolzen 5. Dieses Optimum ist aber stark abhängig von der geometrischen Form der Leiterplatte 1. Jeder Stehbolzen 5, der zusätzlich zur Befestigung der Leiterplatte verwendet wird, erhöht den Zeitaufwand bei der Montage.

Figur 2 zeigt die Elemente der Figur 1 in einer teilmontierten Position, wobei der Stehbolzen 5 bereits durch die kreisförmige Bohrung 2 eingetaucht ist. In dieser Position liegt die Leiterplatte 1 auf dem Bolzenfuß 6 des Stehbolzens 5 auf.

Figur 3 zeigt diese Position aus einer Seitenansicht, wobei die Leiterplatte 1 auf dem Bolzenfuß 6 des Stehbolzens 5 aufliegt. Die Leiterplatte weist in diesem Ausführungsbeispiel an ihrer Unterseite weitere elektrische Kontaktstellen 4 in Form von Lötpunkten auf. Eine an dem Bolzenkopf 7 des Stehbolzens 5 angeordnete Einführschräge 11 ermöglicht ein einfaches Einführen der Leiterplatte 1 und vermeidet zuverlässig ein Verkanten während der Montage.

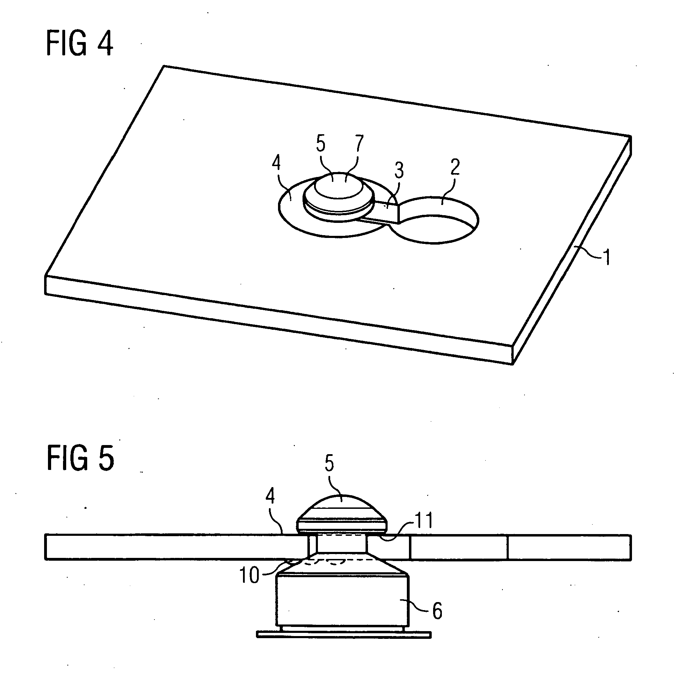

Eine Endposition ist in Figur 4 gezeigt. Dabei ist die Leiterplatte 1 entlang des Langloches 3 so verschoben, dass die Leiterplatte 1 unterhalb des Bolzenkopfes 7 eine klemmende Verbindung einnimmt. Durch die klemmende Verbindung ist ein elektrischer Kontakt des Bolzenkopfes 7 mit den leitenden Kontaktstellen 4 gebildet. Diese Kontaktstellen 4 sind um die schlüssellochförmige Öffnung herum angeordnet.

In Figur 5 ist die Endposition in einer Seitenansicht dargestellt. Die Seitenansicht der Endposition zeigt die Wirkung der kegelförmigen Oberfläche des Bolzenfußes 6 auf die Leiterplatte im Zusammenspiel mit dem Bolzenkopf 7. Wie durch einen Keil wird die Leiterplatte 1 von der kegelförmigen Oberfläche gegen den Bolzenkopf gepresst. Weiter ergibt sich damit ein elektrischer Kontakt mit den Lötpunkten 10 und der kegelförmigen Oberfläche des Bolzenfußes 6, ebenso wie ein leitfähiger Kontakt zwischen dem Bolzenkopf 7 und leitfähigen Kontaktstellen 4.

Es ist somit eine schraubenlose Befestigung einer Leiterplatte in einem Gehäuse ermöglicht, welche schnell und einfach herzustellen ist und darüber hinaus auch die elektrische Kontaktierung der Leiterplatte mit dem Trägerblech und damit mit dem Gehäuse bildet.

Eine Kompensation von unterschiedlichen Dicken der Leiterplatten 1 wird durch die kegelförmige Oberfläche des Bolzenfußes 6 am Übergang zur Verjüngung 8 gebildet. Nach dem Einlegen der Leiterplatte 1 in ein Computergehäuse oder ein Trägerblech 9 wird die Leiterplatte 1 so geführt, dass der Bolzenkopf 5 durch die kreisförmige Öffnung 2 taucht. Anschließend wird die Leiterplatte 1 in Richtung des Langloches 3 verschoben, wobei die Leiterplatte 1 die Schräge der kegelförmigen Oberfläche des Bolzenfußes 6 hinabfährt und am Ende des Langloches 3 eine klemmende Verbindung einnimmt und dabei auch die Endposition erreicht. Damit ist in vorteilhafter Weise ein spielfreier und zuverlässiger Kontakt zwischen den Kontaktstellen 4 der Leiterplatte 1 und dem Stehbolzen 5 gebildet.

### Bezugszeichenliste

- 1: Leiterplatte
- 2: kreisrunde Bohrung
- 3: Langloch
- 4: Kontaktstellen
- 5: Stehbolzen
- 6: Bolzenfuß
- 7: Bolzenkopf
- 8: Verjüngung
- 9: Trägerblech
- 10: Lötpunkten
- 11: Einführschräge

## Patentansprüche

1. Computergehäuse mit einem Trägerblech (9), das zur Befestigung einer Leiterplatte (1) eingerichtet ist, mit zumindest einem Stehbolzen (5) zur Befestigung der Leiterplatte, der an dem Trägerblech (9) angeordnet ist, und einen Bolzenfuß (6) und einen Bolzenkopf (7) aufweist, wobei zwischen dem Bolzenfuß (6) und dem Bolzenkopf (7) der Stehbolzen (5) eine Verjüngung (8) aufweist, und wobei der Bolzenfuß (6) zu der Verjüngung hin kegelförmig ausgebildet ist, **dadurch gekennzeichnet, dass**
der Bolzenkopf (7) eine Grundfläche aufweist welche eine Ebene bildet, die parallel zu einer Oberfläche der aufgenommenen Leiterplatte (1) ist, und die einen elektrischen Kontakt als Massekontakt zwischen der Leiterplatte (1) und dem Computergehäuse bildet.

2. Computergehäuse nach Patentanspruch 1,
**dadurch gekennzeichnet, dass**
der Bolzenfuß (6) zylinderförmig ausgebildet ist, und der Bolzenkopf (7) kegelförmig oder pilzförmig ausgebildet ist, wobei der Bolzenkopf (7) an seiner zum Trägerblech (9) gerichteten Seite eine Einführschräge (11) aufweist.

3. Computergehäuse nach einem der Patentansprüche 1 bis 2,
**dadurch gekennzeichnet, dass**
der Stehbolzen (5) eine elektrisch leitfähige Oberfläche aufweist und eine elektrisch leitfähige Verbindung zwischen dem Stehbolzen (5) und dem Computergehäuse gebildet ist.

4. Computergehäuse nach einem der Patentansprüche 1 bis 3,
**dadurch gekennzeichnet, dass**
der Stehbolzen (5) aus einem metallischen Werkstoff gefertigt ist und eine elektrisch leitfähige Verbindung zwischen dem Stehbolzen (5) und dem Computergehäuse gebildet ist.

5. Computergehäuse nach einem der vorhergehenden Patentansprüche,
**dadurch gekennzeichnet, dass**
der Bolzenfuß (6) und der Bolzenkopf (7) jeweils eine kreisförmige Grundfläche aufweisen, wobei der Durchmesser der Grundflächen voneinander verschieden ist.

6. Computergehäuse nach Patentanspruch 5,
**dadurch gekennzeichnet, dass**
der Durchmesser der Grundfläche des Bolzenfußes (6) größer ist als der Durchmesser der Grundfläche des Bolzenkopfes (7).

7. Computergehäuse nach einem der vorhergehenden Patentansprüche,
**dadurch gekennzeichnet, dass**
die Verjüngung (8) zylindrisch ausgebildet ist.

8. Computergehäuse nach einem der vorhergehenden Patentansprüche,
**dadurch gekennzeichnet, dass**
das Höhenmaß der Verjüngung (8) so eingerichtet ist, dass es gleich oder geringer ist als die Dicke der Leiterplatte (1).

9. Computergehäuse nach einem der vorhergehenden Patentansprüche,
**dadurch gekennzeichnet, dass**
das Trägerblech (9) eine Gehäusewandung des Computergehäuses ist.

10. Computergehäuse nach einem der vorhergehenden Patentansprüche,
**dadurch gekennzeichnet, dass**
der Bolzenfuß (6) an einer zur Innenseite des Compu tergehäuses gerichteten Seite des Trägerblechs (9) angeordnet ist.

11. Anordnung mit einem Computergehäuse gemäß einem der vorhergehenden Patentansprüche und einer Leiterplatte (1), die eine Öffnung aufweist, die dazu eingerichtet ist, mit dem Stehbolzen (5) zusammenzuwirken und deren Abmessungen so ausgebildet sind, dass der Bolzenkopf (7) durch die Öffnung hindurchführbar ist, und die Öffnung eine Verjüngung zu einem Ende hin aufweist, so dass sich in einer Verriegelungsposition der Leiterplatte (1) mit der Verjüngung (8) des Stehbolzens und der Verjüngung der Öffnung eine klemmende Verbindung ergibt.

12. Anordnung nach Patentanspruch 11,
**dadurch gekennzeichnet, dass**
die Öffnung zumindest teilweise von elektrisch leitfähigen Kontaktstellen (4) umgeben ist.

13. Anordnung nach einem der Patentansprüche 11 bis 12,
**dadurch gekennzeichnet, dass**
das Höhenmaß der Verjüngung (8) so eingerichtet ist, dass es gleich oder geringer ist als die Dicke der Leiterplatte (1), so dass die Leiterplatte (1) zwischen Bolzenkopf (7) und Bolzenfuß (6) klemmend befestigt ist.

14. Anordnung nach einem der Patentansprüche 11 bis 13,
**dadurch gekennzeichnet, dass**
die Öffnung eine kreisrunde Bohrung (2) ist, welche einen Mindestdurchmesser umfasst, der zumindest dem Durchmesser des Bolzenkopfes (7) gleich ist, wobei die Bohrung (2) mit einem Langloch (3) in einer Richtung erweitert ist, so dass eine schlüssellochförmige Öffnung gebildet ist, und das Langloch (3) eine Mindestbreite aufweist, die zumindest gleich dem Durchmesser der zylindrischen Verjüngung ist.

15. Anordnung nach einem der vorhergehenden Patentansprüche 11 bis 14,
**dadurch gekennzeichnet, dass**
die Leiterplatte (1) ein Motherboard eines Computers ist.

## Claims

1. Computer housing having a carrier plate (9) which is designed for mounting a printed circuit board (1), having at least one stud bolt (5) for mounting the printed circuit board, which stud bolt is arranged on the carrier plate (9) and has a bolt root (6) and a bolt head (7), with the stud bolt (5) having a tapered portion (8) between the bolt root (6) and the bolt head (7), and with the bolt root (6) being of conical design in the direction of the tapered portion, **characterized in that** the bolt head (7) has a base area which forms a plane which is parallel to a surface of the held printed circuit board (1), and which forms an electrical contact as a ground contact between the printed circuit board (1) and the computer housing.

2. Computer housing according to Patent Claim 1, **characterized in that** the bolt root (6) is of cylindrical design and the bolt head (7) is of conical or mushroom-shaped design, with the bolt head (7) having an insertion slope (11) on its side which is directed towards the carrier plate (9).

3. Computer housing according to either of Patent Claims 1 and 2, **characterized in that** the stud bolt (5) has an electrically conductive surface, and an electrically conductive connection is formed between the stud bolt (5) and the computer housing.

4. Computer housing according to one of Patent Claims 1 to 3, **characterized in that** the stud bolt (5) is produced from a metal material, and an electrically conductive connection is formed between the stud bolt (5) and the computer housing.

5. Computer housing according to one of the preceding patent claims, **characterized in that** the bolt root (6) and the bolt head (7) each have a circular base area, with the diameter of the base areas being different from one another.

6. Computer housing according to Patent Claim 5, **characterized in that** the diameter of the base area of the bolt root (6) is larger than the diameter of the base area of the bolt head (7).

7. Computer housing according to one of the preceding patent claims, **characterized in that** the tapered portion (8) is of cylindrical design.

8. Computer housing according to one of the preceding patent claims, **characterized in that** the vertical extent of the tapered portion (8) is designed such that it is equal to or less than the thickness of the printed circuit board (1).

9. Computer housing according to one of the preceding patent claims, **characterized in that** the carrier plate (9) is a housing wall of the computer housing.

10. Computer housing according to one of the preceding patent claims, **characterized in that** the bolt root (6) is arranged on a side of the carrier plate (9) which is directed towards the inner face of the computer housing.

11. Arrangement having a computer housing according to one of the preceding patent claims and a printed circuit board (1) which has an opening which is designed to interact with the stud bolt (5) and of which the dimensions are such that the bolt head (7) can be routed through the opening, and the opening has a tapered portion in the direction of an end, and therefore a clamping connection is produced between the tapered portion (8) of the stud bolt and the tapered portion of the opening in a locking position of the printed circuit board (1).

12. Arrangement according to Patent Claim 11, **characterized in that** the opening is at least partially surrounded by electrically conductive contact points (4).

13. Arrangement according to either of Patent Claims 11 and 12, **characterized in that** the vertical extent of the tapered portion (8) is designed such that it is equal to or less than the thickness of the printed circuit board (1), and therefore the printed circuit board (1) is fixed in a clamping manner between the bolt head (7) and the bolt root (6).

14. Arrangement according to one of Patent Claims 11 to 13, **characterized in that** the opening is a circular bore (2) which comprises a minimum diameter which is at least equal to the diameter of the bolt head (7), with the bore (2) being widened by an elongate hole (3) in one direction, and therefore a keyhole-shaped opening is formed, and the elongate hole (3) has a minimum width which is at least equal to the diameter of the cylindrical tapered portion.

15. Arrangement according to one of the preceding Patent Claims 11 to 14, **characterized in that** the printed circuit board (1) is a motherboard of a computer.

## Revendications

1. Boîtier d'ordinateur comprenant une tôle porteuse (9) qui est aménagée pour la fixation d'un circuit imprimé (1), comprenant au moins un boulon d'entretoisement (5) pour la fixation du circuit imprimé, lequel est monté sur la tôle porteuse (9) et présente un pied de boulon (6) ainsi qu'une tête de boulon (7), le boulon d'entretoisement (5) présentant un rétrécissement (8) entre le pied de boulon (6) et la tête de boulon (7) et le pied de boulon (6) étant réalisé en forme de cône en direction du rétrécissement, **caractérisé en ce que** la tête de boulon (7) présente une surface de base qui forme un plan, lequel est parallèle avec une surface du circuit imprimé (1) accueilli et qui forme un contact électrique sous la forme d'un contact de masse entre le circuit imprimé (1) et le boîtier d'ordinateur.

2. Boîtier d'ordinateur selon la revendication 1, **caractérisé en ce que** le pied de boulon (6) est réalisé sous forme cylindrique et la tête de boulon (7) est réalisée en forme de cône ou en forme de champignon, la tête de boulon (7) présentant un biseau d'introduction (11) sur son côté orienté vers la tôle porteuse (9).

3. Boîtier d'ordinateur selon l'une des revendications 1 à 2, **caractérisé en ce que** le boulon d'entretoisement (5) présente une surface électriquement conductrice et une liaison électriquement conductrice est formée entre le boulon d'entretoisement (5) et le boîtier d'ordinateur.

4. Boîtier d'ordinateur selon l'une des revendications 1 à 3, **caractérisé en ce que** le boulon d'entretoisement (5) est fabriqué dans un matériau métallique et une liaison électriquement conductrice est formée entre le boulon d'entretoisement (5) et le boîtier d'ordinateur.

5. Boîtier d'ordinateur selon l'une des revendications précédentes, **caractérisé en ce que** le pied de boulon (6) et la tête de boulon (7) présentent respectivement une surface de base de forme circulaire, les diamètres des surfaces de base étant différents l'un de l'autre.

6. Boîtier d'ordinateur selon la revendication 5, **caractérisé en ce que** le diamètre de la surface de base du pied de boulon (6) est supérieur au diamètre de la surface de base de la tête de boulon (7).

7. Boîtier d'ordinateur selon l'une des revendications précédentes, **caractérisé en ce que** le rétrécissement (8) est réalisé sous forme cylindrique.

8. Boîtier d'ordinateur selon l'une des revendications précédentes, **caractérisé en ce que** la cote de hauteur du rétrécissement (8) est conçue de telle sorte qu'elle est égale ou inférieure à l'épaisseur du circuit imprimé (1).

9. Boîtier d'ordinateur selon l'une des revendications précédentes, **caractérisé en ce que** la tôle porteuse (9) est une paroi du boîtier d'ordinateur.

10. Boîtier d'ordinateur selon l'une des revendications précédentes, **caractérisé en ce que** le pied de boulon (6) est disposé sur un côté de la tôle porteuse (9) qui est dirigé vers le côté intérieur du boîtier d'ordinateur.

11. Arrangement comprenant un boîtier d'ordinateur selon l'une des revendications précédentes et un circuit imprimé (1) qui présente une ouverture, laquelle est conçue pour interagir avec le boulon d'entretoisement (5) et dont les dimensions sont choisies de telle sorte que la tête de boulon (7) peut passer à travers l'ouverture, et l'ouverture présente un rétrécissement vers une extrémité de sorte que dans une position de verrouillage du circuit imprimé (1), une liaison bloquante est obtenue avec le rétrécissement (8) du boulon d'entretoisement et le rétrécissement de l'ouverture.

12. Arrangement selon la revendication 11, **caractérisé en ce que** l'ouverture est au moins partiellement entourée de points de contact (4) électriquement conducteurs.

13. Arrangement selon l'une des revendications 11 à 12, **caractérisé en ce que** la cote de hauteur du rétrécissement (8) est conçue de telle sorte qu'elle est égale ou inférieure à l'épaisseur du circuit imprimé (1), de sorte que le circuit imprimé (1) est fixé avec blocage entre la tête de boulon (7) et le pied de boulon (6).

14. Arrangement selon l'une des revendications 11 à 13, **caractérisé en ce que** l'ouverture est un orifice (2) circulaire rond qui comprend un diamètre minimum, lequel est au moins égal au diamètre de la tête de boulon (7), l'orifice (2) étant élargi dans une direction avec un trou oblong (3) de manière à former une ouverture en forme de trou de serrure et le trou oblong (3) présente une largeur minimale qui est au moins égale au diamètre du rétrécissement cylindrique.

15. Arrangement selon l'une des revendications précédentes 11 à 14, **caractérisé en ce que** le circuit imprimé (1) est une carte-mère d'un ordinateur.
